Europäisches Patentamt

European Patent Office

Office européen des brevets

(11) Veröffentlichungsnummer: **0 068 535**
**A2**

(12) **EUROPÄISCHE PATENTANMELDUNG**

(21) Anmeldenummer: **82200668.0**

(22) Anmeldetag: **02.06.82**

(51) Int. Cl.³: **H 03 K 7/06,** H 03 K 13/02,
H 04 L 27/12

(30) Priorität: **20.06.81 DE 3124301**

(43) Veröffentlichungstag der Anmeldung: **05.01.83**
**Patentblatt 83/1**

(84) Benannte Vertragsstaaten: **DE FR GB IT**

(71) Anmelder: **Philips Patentverwaltung GmbH,
Steindamm 94, D-2000 Hamburg 1 (DE)**

(84) Benannte Vertragsstaaten: **DE**

(71) Anmelder: **N.V. Philips' Gloeilampenfabrieken,
Groenewoudseweg 1, NL-5621 BA Eindhoven (NL)**

(84) Benannte Vertragsstaaten: **FR GB IT**

(72) Erfinder: **Demmer, Walter, Sorthmannweg 15,
D-2000 Hamburg 54 (DE)**
Erfinder: **Rabeler, Thorwald, Ubierweg 12a,
D-2000 Hamburg 61 (DE)**

(74) Vertreter: **Poddig, Dieter et al, Philips Patentverwaltung
GmbH Steindamm 94, D-2000 Hamburg 1 (DE)**

(54) **Anordnung zum Erzeugen einer Folge von digitalen Ausgangssignalen entsprechend einem frequenzmodulierten Signal.**

㉘⑦ Das modulierende Steuersignal wird in digitaler Form einem Akkumulator aus einem Addierer und einem nachgeschalteten Register zugeführt, so dass eine Folge von Dualzahlen entsprechend einem digitalisierten sägezahnförmigen Signal gebildet wird, bei dem die Modulationsinformation in der Steigung des Sägezahns liegt. Durch Nachschaltung eines Komplementbildners, der bei jedem zweiten Übertragssignal des Addierers auf Komplementbildung umgeschaltet wird, wird jede zweite Periode des sägezahnförmigen Signals quasi umgeklappt und ein dreiecksförmiges Signal mit halber Frequenz gebildet. Durch einen Zuordner mit einem Festwertspeicher kann das digitale dreiecksförmige Signal in ein digitales sinusförmiges Signal umgewandelt werden. Anstatt im Komplementbildner kann auch das vom Akkumulator gelieferte digitale dreiecksförmige Signal direkt im Zuordner in ein sinusförmiges Signal umgewandelt werden, wobei dann jedoch eine doppelte Speicherkapazität notwendig ist. Ein bevorzugtes Anwendungsgebiet besteht bei Video-Magnetbandgeräten.

Anordnung zur Erzeugung einer Folge von digitalen Ausgangssignalen entsprechend einem frequenzmodulierten Signal

Die Erfindung betrifft eine Anordnung zur Erzeugung einer
Folge von digitalen Ausgangssignalen, die zu gleichmäßig
verteilten Zeitpunkten gewonnenen Abtastwerten eines
periodischen analogen Signals entsprechen, dessen Momentanfrequenz durch ein Steuersignal frequenzmoduliert ist.

Für die Erzeugung eines frequenzmodulierten analogen Signals
sind eine Vielzahl verschiedener Schaltungsanordnungen bekannt. Derartige analoge Schaltungen sind jedoch kompliziert aufgebaut und erfordern Spulen und Kondensatoren,
so daß eine in einem Halbleiter-Kristall integrierte Ausführung solcher Schaltungen nicht ohne weiteres möglich
ist.

Dagegen lassen sich digitale Schaltungen sehr günstig
integrieren,und außerdem tritt bei der digitalen Verarbeitung von analogen Signalen außer der Amplituden- und
Zeitdiskretisierung bei der Digitalisierung der analogen
Signale keine weitere unerwünschte Signalveränderung auf.
Daher ist es in vielen Anwendungsfällen erwünscht, insbesondere bei denen bisher analoge frequenzmodulierte Signale
verarbeitet werden, diese in digitaler Form möglichst
direkt mit digitalen Schaltungen zu erzeugen.

Aus der US-PS 3,787,785 ist eine Anordnung bekannt, mittels
deren ein Signal durch ein anderes Signal auf digitalem
Wege moduliert wird. Darin wird ein Phasensprungmodulator
beschrieben, der auch mehrere phasensprungmodulierte Signale
zeitverschachtelt erzeugen kann. Dies erfolgt mit Hilfe digitaler Zahlengeneratoren, die einen Festwertspeicher ansteuern,
an dessen digitalen Ausgang ein Digital-Analog-Wandler und ein Tiefpaßfilter angeschlossen ist, so daß schließlich
ein analoges Signal begrenzter Bandbreite erhalten wird.
Die Erzeugung eines digitalisierten frequenzmodulierten
Signals ist damit nicht ohne weiteres möglich.

Aufgabe der Erfindung ist es daher, eine Anordnung der
eingangs genannten Art anzugeben, mit der die digitalen
Ausgangssignale entsprechend einem frequenzmodulierten
Signal auf rein digitalem Weg gewonnen werden können,
wobei ein großer Frequenzhub mit hoher Linearität bei
einem großen Verhältnis von höchster Signalfrequenz zur
Mittenfrequenz des frequenzmodulierten Signals erzielt
werden kann. Diese Aufgabe wird erfindungsgemäß dadurch
gelöst, daß ein digital arbeitender Akkumulator aus
einer ersten digitalen Recheneinheit und einem Speicherregister vom Steuersignal zu gleichmäßig verteilten Zeitpunkten abgeleitete Dualzahlen in einem begrenzten Wertebereich aufaddiert und daß die Folge der digitalen Ausgangssignale von der Folge der im Speicherregister auftretenden
digitalen Werte abgeleitet ist. Auf diese Weise entsprechen
die Differenzen zwischen jeweils zwei aufeinanderfolgenden
digitalen Ausgangssignalen dem Steuersignal, was grundsätzlich einer Frequenzmodulation völlig entspricht. Dabei
entspricht die Folge der digitalen Ausgangssignale im
analogen Bereich einem sägezahnförmig verlaufenden periodischen Signal mit vom Steuersignal abhängiger Steigung.
Da die gleichmäßig verteilten Zeitpunkte von einem quarzgesteuerten Oszillator abgeleitet werden können, der auch
den Akkumulator steuert, entsteht somit ein exakt definiertes linear frequenzmoduliertes Signal, das auch durch
verschiedene Einflüsse wie Temperaturgang, Alterung oder
Betriebsspannung praktisch nicht beeinflußt wird, im Gegensatz zu analogen Schaltungen, die Spulen und Kondensatoren
verwenden. Da solche Elemente bei der erfindungsgemäßen
Anordnung nicht vorhanden sind, läßt diese sich leicht vollständig integrieren. Die Linearität der Frequenzmodulation ist auch bei sehr großem Hub (Breitband-FM) völlig gewährleistet.

Wenn beispielsweise die Aufzeichnung einer derartigen Folge von digitalen Ausgangssignalen auf einem Magnetband in analoger Form gewünscht wird, kann mit Hilfe eines Digital-Analog-Wandlers und eines Tiefpaßfilters ein bandbreitenbegrenztes frequenzmoduliertes analoges Signal erzeugt werden, mit dem der Schreibkopf des Magnetbandgerätes angesteuert werden kann. Bei einem sägezahnförmigen Signal sind allerdings Komponenten mit relativ hoher Amplitude bei hohen Frequenzen enthalten. Um dem Ideal eines nahezu sinusförmigen Signals nahezukommen, ist es daher nach einer Ausgestaltung der Erfindung zweckmäßig, daß die digitale Recheneinheit einen Übertragsausgang aufweist, der ein Übertragssignal abgibt, wenn bei einer Addition der begrenzte Wertebereich überschritten wird, und daß das Übertragssignal eine Untersetzerstufe steuert, deren Untersetzersignal einen Teil des digitalen Ausgangssignals bildet. Dieses Untersetzersignal kann beispielsweise das Vorzeichen der digitalen Ausgangssignale entsprechend einem nullsymmetrisch verlaufenden Sägezahnsignal nach jeder Periode des Sägezahns invertieren. Dadurch entsteht dann eine Folge von digitalen Ausgangssignalen, die einem dreieckförmig verlaufenden Signal entsprechen. Eine besonders günstige Möglichkeit zur Annäherung eines solchen dreieckförmigen Signals durch die digitalen Ausgangssignale kann nach einer weiteren Ausgestaltung der Erfindung zweckmäßig dadurch erreicht werden, daß dem Speicherregister ein vom Untersetzersignal gesteuerter binärer Komplementbildner nachgeschaltet ist. Die dadurch erzeugten digitalen Ausgangssignale brauchen dann nicht mit einem Vorzeichensignal versehen zu sein.

Um eine Folge von digitalen Ausgangssignalen zu erzeugen, die einem sinusförmig verlaufenden frequenzmodulierten Signal entspricht, ist es zweckmäßig, daß dem Speicherregister bzw. dem Komplementbildner ein Zuordner nachgeschaltet ist, der bei jeder zugeführten Dualzahl eine Ausgangs-Dualzahl entsprechend dem Wert einer Sinusschwingung zu einem der zugeführten Dualzahl entsprechenden Argument erzeugt, wobei der Wertebereich der zugeführten Dualzahlen dem vollständigen Bereich einer Sinusschwingung zwischen beiden Extremwerten entspricht. Ein solcher Zuordner kann in einfacher Weise als Festwertspeicher ausgebildet sein. Dabei kann dann das Untersetzersignal den Speicherbereich periodisch umschalten, so daß aus der vom Speicherregister abgegebenen Folge von digitalen Signalen entsprechend einem sägezahnförmigen Signal unmittelbar die digitalen Ausgangssignale entsprechend einem sinusförmig verlaufenden Signal erzeugt werden, oder der Zuordner wird dem Komplementbildner nachgeschaltet.

In vielen Fällen ist das Steuersignal ein analoges Signal. Eine Ausgestaltung der Erfindung ist daher dadurch gekennzeichnet, daß bei einem analogen Steuersignal ein Analog-Digital-Wandler aus dem Steuersignal die abgeleiteten Dualzahlen erzeugt. Ein solcher Analog-Digital-Wandler kann ohne weiteres bei integriertem Aufbau der gesamten Anordnung mit integriert werden, so daß praktisch keine externen Bauelemente notwendig sind.

Häufig ist ein derartiges analoges Steuersignal auf die Masseleitung bezogen. Um in diesen Fällen eine mittlere Frequenz des frequenzmodulierten Signals, das durch die Folge von digitalen Ausgangssignalen gebildet wird, bzw. eine minimale Frequenz dieses Signals auf einfache Weise zu gewährleisten, ist es zweckmäßig, daß eine zweite arithmetische Recheneinheit vorgesehen ist, die zu jeder

vom Steuersignal abgeleiteten Dualzahl eine konstante
Dualzahl addiert und diese Summe der ersten Recheneinheit
zuführt. Auf diese Weise wird das Eingangssignal also
mit digitalen Mitteln um einen wählbaren Betrag entsprechend
der konstanten Dualzahl verschoben, so daß keine Bauelemente für eine analoge Verschiebung des analogen Steuersignals notwendig sind.

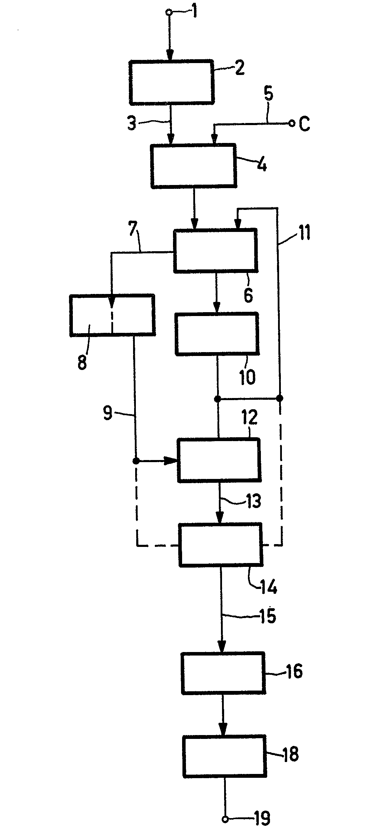

Ein Ausführungsbeispiel einer erfindungsgemäßen Anordnung
ist in der Zeichnung dargestellt. Darin wird dem Eingang 1
ein analoges Steuersignal zugeführt und in dem Analog-
Digital-Wandler 2 in eine Folge von Dualzahlen entsprechend
dem Wert des analogen Steuersignals zu gleichmäßig verteilten Zeitpunkten umgewandelt. Diese Umwandlung wird durch
ein nicht dargestelltes Taktsignal gesteuert, das auch die
Auftrittszeitpunkte der digitalen Ausgangssignale bestimmt.
Zweckmäßig erfolgt die Abtastung des Steuersignals und die
Umwandlung in Dualzahlen durch den Analog-Digital-Wandler 2
mit der gleichen Geschwindigkeit, wie die digitalen Ausgangssignale auftreten, da dann die Verarbeitungsgeschwindigkeit
in der ganzen Anordnung einheitlich ist. Falls das Steuersignal jedoch bereits in digitaler Form zugeführt wird,
ist der Analog-Digital-Wandler selbstverständlich unnötig.
Es ist nur wesentlich, daß das Steuersignal in Form zeitdiskreter digitaler Abtastwerte vorliegt.

Die am Ausgang des Wandlers 2 auftretenden Dualzahlen,
deren Wert bei der höchsten Amplitude des Steuersignals
nur einen Bruchteil des maximalen Wertebereichs des
Addierers 6 beträgt, werden vorzugsweise bitparallel über
die Leitung 3 dem einen Eingang eines Addierers 4 zugeführt,
dessen anderer Eingang 5 einen konstanten Zahlenwert C erhält. Am Ausgang des Addierers 4 treten somit die Dualzahlen des Wandlers 2, erhöht um die Konstante C, in der
gleichen Folge auf, wobei eine gewisse Zeitverschiebung durch die Verarbeitungsgeschwindigkeit des Addierers 4 vernachlässigt wird, daß diese sich für den Modulations- vorgang nicht auswirkt. Auch ein dem Addierer 4 üblicherweise nachgeschaltetes Zwischenregister ist hier der Übersichtlichkeit halber nicht dargestellt. Ferner ist zu bemerken, daß bei bitparalleler Übertragung der Dualzahlen die Leitung 3 ebenso wie die anderen Verbindungen der Elemente in der Figur mit Ausnahme der Leitungen 7 und 9 tatsächlich aus einer Anzahl paralleler Verbindungen besteht, die hier der Übersichtlichkeit halber als nur eine Leitung dargestellt sind.

Die vom Addierer 4 erzeugten Dualzahlen entsprechen dem um einen konstanten Wert C verschobenen Steuersignal, wobei dieser Wert C die untere Frequenz des modulierten Signals bestimmt, und stellen das modulierende Signal dar, das dem einen Eingang eines Addierers 6 zugeführt wird. Der Ausgang des Addierers 6 führt auf einen Speicher 10, dessen Ausgang über die Leitung 11 mit dem anderen Eingang des Addierers 6 verbunden ist. Der Addierer 6 und der Speicher 10 bilden somit einen Akkumulator, der die am einen Eingang zugeführten Werte aufeinanderfolgend aufsummiert. Unter Vernachlässigung des Übertrags bei der Aufsummierung durch Überschreiten des Wertebereichs des Akkumulators, der durch die Stellenzahl des Addierers 6 und der gleich großen Stellenzahl des Speichers 10 bestimmt ist, entsteht also auf der Leitung 11 eine Folge von Dualzahlen, die im analogen Bereich einem sägezahnförmigen Signal entsprechen, bei dem der momentane Wert des modulierenden Signals in der momentanen Steigung des Sägezahns und damit in dessen Momentanfrequenz enthalten ist. Damit stellt die Folge der Dualzahlen auf der Leitung 6 bereits ein digitales frequenzmoduliertes Signal dar. Da ein derartiges Signal bei Rücktransformation in den analogen Bereich jedoch einen sehr hohen Oberwellengehalt aufweist, ist es zweckmäßig, das sägezahnförmige Signal in ein anderes Signal mit einem geringeren Oberwellenanteil im analogen Bereich umzuwandeln.

Hierfür wird der Übertragsausgang 7 des Addierers 6 mit dem Untersetzereingang einer Untersetzerstufe 8 verbunden, die durch eine bistabile Kippstufe gebildet sein kann. Das Untersetzersignal am Ausgang 9 dieser Untersetzerstufe 8 wechselt somit jeweils nach einer vollen Periode der Sägezahnschwingung, die durch die Folge der Dualzahlen auf der Leitung 6 gebildet wird, seinen Wert, d.h. wenn die Dualzahlen auf der Leitung 11 den durch die Stellenzahl des Addierers 6 vorgegebenen Wertebereich einmal durchlaufen haben und wieder am unteren Ende des Wertebereichs beginnen. Das Untersetzersignal auf der Leitung 9 führt nun auf den Steuereingang eines Komplementbildners 12, dessen Dateneingang ebenfalls mit der Leitung 11 verbunden ist. Bei dem einen Signalwert auf der Leitung 9 gibt der Komplementbildner 12 auf der Ausgangsleitung 13 die Dualzahlen auf der Leitung 11 unmittelbar aus, während beim anderen Wert auf der Leitung 9 das Komplement der Dualzahlen auf der Leitung 11 zum höchsten Wert des durch den Addierer 6 bestimmten Wertebereichs auf der Ausgangsleitung 13 abgegeben wird. Die Folge der Dualzahlen auf der Leitung 13 stellen somit ein digitalisiertes dreieckförmig verlaufendes Signal dar, dessen Periodendauer doppelt so lang ist wie das sägezahnförmige Signal entsprechend den Dualzahlen auf der Leitung 11, wobei jedoch weiterhin der Wert des am Eingang 1 zugeführten Steuersignals in der momentanen Steigung des dreieckförmigen Signals gemäß den Dualzahlen auf der Leitung 13 enthalten ist. Die Frequenzhalbierung durch den Komplementbildner 12 ergibt somit keinen Informationsverlust. Eine andere Möglichkeit, eine Folge von Dualzahlen aus den auf der Leitung 11 auftretenden Dualzahlen zu erzeugen, die ebenfalls im analogen Bereich ein oberwellenarmes Signal darstellt, wird etwas
später erläutert.

Die Ausgangsleitung 13 des Komplementbildners 12 ist mit
einem Zuordner 14 verbunden, der vorzugsweise einen Festwertspeicher enthält und der durch die Dualzahlen auf der
Leitung 13 adressiert wird. An jedem Speicherplatz ist
der digitale Wert einer Sinusschwingung für das Argument
gespeichert, das durch die zugeführte Adresse dargestellt
wird, wobei der gesamte Wertebereich der Adressen, d.h.
der auf der Leitung 13 zugeführten Dualzahlen, einer
halben Sinusschwingung vom einen Extremwert bis zum
entgegengesetzten Extremwert entspricht, d.h. von $90^{o}$
bis $270^{o}$. Auf diese Weise gibt der Zuordner 14 auf der
Ausgangsleitung 15 Dualzahlen ab, die einer mit dem am
Eingang 1 zugeführten Steuersignal frequenzmodulierten
Sinusschwingung entsprechen. Diese Dualzahlen auf der
Leitung 15 können nun gewünschtenfalls digital weiterverarbeitet werden, oder für die Aufzeichnung des durch
die Dualzahlen dargestellten frequenzmodulierten Signals
auf einem Magnetband werden diese Dualzahlen einem Digital-
Analog-Wandler 16 zugeführt, der analoge Abtastwerte entsprechend diesen Dualzahlen liefert, und die Folge dieser
Abtastwerte wird einem Tiefpaßfilter 18 zugeführt, so daß
am Ausgang 19 eine kontinuierliche frequenzmodulierte
Sinusschwingung auftritt.

Die vorher erwähnte andere Art, eine Folge von digitalen
Ausgangssignalen zu erzeugen, die einem oberwellenarmen
analogen Signal entspricht, kann dadurch erreicht werden,
daß die Leitung 11 mit einem Eingang des Zuordners 14
verbunden wird, wie durch die gestrichelte Verbindung
angedeutet ist. Ferner wird auch das Übertragssignal auf
der Leitung 9 dem Zuordner 14 zugeführt. Der Einfachheit
halber werde wieder angenommen, daß der Zuordner 14 einen Festwertspeicher enthält, der durch die Dualzahlen auf
der Leitung 11 adressiert wird. Dieser Festwertspeicher
enthält dann aber nicht nur die digitalisierten Abtastwerte einer halben Sinusschwingung, sondern einer vollen
Sinusschwingung, und zwar vorzugsweise beginnend bei dem
einen Extremwert, beispielsweise entsprechend 90°. Die
Leitung 9 ist dann mit dem Bit höchster Wertigkeit des
Adresseneingangs verbunden. Auf diese Weise wird durch
die Folge der Dualzahlen auf der Leitung 11 entsprechend
einem sägezahnförmigen Signal in der einen Periode dieses
Sägezahns der Festwertspeicher in dem Zuordner 14 so angesteuert, daß auf der Ausgangsleitung 15 nacheinander die
Abtastwerte einer Sinusschwingung vom höchsten bis zum
niedrigsten Wert abgegeben werden, und in der folgenden
Periode der Sägezahnschwingung werden die Abtastwerte einer
Sinusschwingung vom niedrigsten bis zum höchsten Wert entsprechend abgegeben. Auf diese Weise erscheint auf der
Ausgangsleitung 15 die gleiche Folge von Dualzahlen wie
bei der vorher beschriebenen Verwendung des Komplementbildners 12, der nun entfallen kann, Dagegen muß der Festwertspeicher im Zuordner 14 bei dieser zuletzt beschriebenen
Lösung jedoch die doppelte Speicherkapazität aufweisen.

Unter der Voraussetzung, daß alle Schaltungselemente mit
der gleichen Taktfrequenz $f_T$ arbeiten, besteht für die
Frequenz $f_{FM}$ der frequenzmodulierten Sinusschwingung
am Ausgang 19 folgender Zusammenhang  mit dem am Eingang 1
zugeführten Steuersignal E und dem Wertebereich N der
Anordnung

$$f_{FM} = f_T \cdot \frac{E + C}{2 \cdot N}.$$

Da der Wertebereich N sowie der konstante Wert C exakt
festliegen und die Taktfrequenz mit Hilfe eines quarzgesteuerten Oszillators sehr genau konstant gehalten werden kann, ist die Genauigkeit der Frequenzmodulation also sehr
groß und somit wesentlich größer, als bei vergleichbarem
Aufwand mit analogen Mitteln erreichbar.

In einem praktischen Ausführungsbeispiel für die Anwendung
bei einem Videobandgerät wurde die Taktfrequenz $f_T$ zu
17,73 MHz und die Bitbreite des Addierers 6 und damit auch
des Addierers 4 sowie der übrigen Elemente zu 10 Bit
entsprechend einem Wertebereich von 1,024 gewählt. Bei
einem konstanten Wert C von 381 und einem Wertebereich
für das vom Analog-Digital-Wandler 2 abgegebene digitalisierte Steuersignal E von 0 bis 173 liegt die Frequenz
$f_{FM}$ des frequenzmodulierten Signals am Ausgang 19 im
Bereich von 3,3 bis 4,8 MHz.

PATENTANSPRÜCHE:

1. Anordnung zur Erzeugung einer Folge von digitalen Ausgangssignalen, die zu gleichmäßig verteilten Zeitpunkten gewonnenen Abtastwerten eines periodischen analogen Signals entsprechen, dessen Momentanfrequenz durch ein Steuersignal frequenzmoduliert ist, dadurch gekennzeichnet, daß ein digital arbeitender Akkumulator (6, 10) aus einer ersten digitalen Recheneinheit (6) und einem Speicherregister (10) vom Steuersignal zu gleichmäßig verteilten Zeitpunkten abgeleitete Dualzahlen in einem begrenzten Wertebereich aufaddiert und daß die Folge der digitalen Ausgangssignale von der Folge der im Speicherregister (10) auftretenden digitalen Werte abgeleitet ist.

2. Anordnung nach Anspruch 1, dadurch gekennzeichnet, daß die digitale Recheneinheit (6) einen Übertragsausgang (7) aufweist, der ein Übertragssignal abgibt, wenn bei einer Addition der begrenzte Wertebereich überschritten wird, und daß das Übertragssignal eine Untersetzerstufe (8) steuert, deren Untersetzersignal einen Teil des digitalen Ausgangssignals bildet.

3. Anordnung nach Anspruch 2, dadurch gekennzeichnet, daß dem Speicherregister (10) ein vom Untersetzersignal gesteuerter binärer Komplementbildner (12) nachgeschaltet ist.

4. Anordnung nach Anspruch 1 oder einem der folgenden, dadurch gekennzeichnet, daß dem Speicherregister (10) bzw. dem Komplementbildner (12) ein Zuordner (14) nachgeschaltet ist, der bei jeder zugeführten Dualzahl eine Ausgangs-Dualzahl entsprechend dem Wert einer Sinusschwingung zu einem der zugeführten Dualzahl entsprechenden Argument erzeugt, wobei der Wertebereich der zugeführten Dualzahlen dem vollständigen Bereich einer Sinusschwingung
zwischen beiden Extremwerten entspricht.

5.     Anordnung nach Anspruch 1 oder einem der folgenden,
dadurch gekennzeichnet, daß dem Speicherregister (10)
bzw. dem Zuordner (14) ein Digital-Analog-Wandler (16)
und ein Tiefpaßfilter (18) nachgeschaltet sind.

6.     Anordnung nach Anspruch 1 oder einem der folgenden,
dadurch gekennzeichnet, daß bei einem analogen Steuersignal ein Analog-Digital-Wandler (2) aus dem Steuersignal die abgeleiteten Dualzahlen erzeugt.

7.     Anordnung nach Anspruch 1 oder einem der folgenden,
dadurch gekennzeichnet, daß eine zweite arithmetische
Recheneinheit (4) vorgesehen ist, die zu jeder vom Steuersignal abgeleiteten Dualzahl eine konstante Dualzahl addiert
und diese Summe der ersten Recheneinheit (6) zuführt.